# EUROPEAN PATENT APPLICATION

(11) **EP 4 697 153 A1**
(43) Date of publication of application: **18.02.2026**
(21) Application number: 23933028.5
(22) Date of filing: 13.04.2023
(51) Int. Cl.: G06F 3/06, G06F 3/08

(54) **ONBOARD CONTROL SYSTEM**

(71) Applicant: Astemo, Ltd., Chiyoda-ku, Tokyo 1000004 (JP)
(72) Inventor: IKEGAYA Katsumi, Hitachinaka-shi, Ibaraki 312-8503 (JP); ARATA Atsushi, Hitachinaka-shi, Ibaraki 312-8503 (JP); MASUBUCHI Takumi, Hitachinaka-shi, Ibaraki 312-8503 (JP)
(74) Representative: Strehl & Partner mbB
(86) International application number: PCT/JP2023/015054
(87) International publication number: WO 2024/214252

(57) **Abstract**

An onboard control system according to an embodiment of the present invention includes a storage device that is used in controlling an automobile, a failure symptom diagnosis device that diagnoses a failure symptom of the storage device, and a frequency changing circuit that changes an operation frequency of the storage device to a second frequency, which is higher than a first frequency that is a frequency used during normal control of the automobile, when the failure symptom diagnosis device diagnoses the storage device.

## Description

### Technical Field

The present invention relates to an onboard control system for predictive diagnosis of a failure in which an operation speed is delayed due to aged deterioration of an onboard semiconductor storage device.

### Background Art

It is considered that an operation rate of an automobile will greatly increase to several times to several 10 times in the near future due to improvement and expansion of automatic driving of the automobile and advanced driving support technology, popularization of car sharing, automatic distribution, and the like. It is predicted that a period until a semiconductor device used in an automobile fails will be shortened due to a significant increase in the operation rate. However, in the semiconductor device, it is difficult to secure long-term reliability several times to several 10 times that of the conventional semiconductor device in terms of both cost and technology, and in the future, a method of maintaining the function and performance of an automobile by component replacement or unit replacement is considered to be the mainstream.

In such a background, it is necessary to accurately detect a failure symptom before the semiconductor device fails and notify a driver of the failure symptom. Specifically, by monitoring the state of each semiconductor device mounted on an automobile, calculating the time until each semiconductor device fails, detecting a component that needs to be replaced, and replacing only a target component, it is possible to reduce the replacement cost as compared with a case where replacement is performed with a predetermined period.

A large number of semiconductor storage devices are mounted in advanced operation systems that perform advanced control, and high reliability is required. The deterioration phenomenon of the semiconductor storage device includes an increase in leakage of retained charges due to deterioration of an insulating film of a memory cell, a delay in read/write time due to a change in threshold voltage or an increase in wiring resistance, and finally causes dielectric breakdown or malfunction. By monitoring these deterioration phenomena of the semiconductor storage device, it is possible to predict failure. As a technique for predicting such a failure of the semiconductor storage device, for example, there is PTL 1. According to PTL 1, while a read voltage of a nonvolatile memory is gradually changed, the distribution of the threshold of the memory is monitored, and the degree of deterioration is determined from the change of the distribution of the threshold.

### Citation List

### Patent Literature

PTL 1: JP 2013-122793 A

### Summary of Invention

### Technical Problem

As described above, the deterioration mode of the semiconductor storage device includes a delay in the operation time due to an increase in wiring resistance or the like in addition to the change in the threshold voltage. In particular, a storage device such as a DRAM or an SRAM has a high operation frequency, and there is a possibility that the storage device becomes defective due to an operation delay caused by aged deterioration. The present invention has been made in view of such a problem, and an object of the present invention is to provide a technique for performing a failure prediction with respect to a delay of an operation time due to aged deterioration.

### Solution to Problem

In order to solve the above problem, an onboard control system according to an embodiment of the present invention includes a storage device that is used in controlling an automobile, a failure symptom diagnosis device that diagnoses a failure symptom of the storage device, and a frequency changing circuit that changes an operation frequency of the storage device to a second frequency, which is higher than a first frequency that is a frequency used during normal control of the automobile, when the failure symptom diagnosis device diagnoses the storage device.

### Advantageous Effects of Invention

According to the present invention, by performing the diagnosis at a frequency higher than a frequency at which the onboard control system is actually operated, it is possible to detect a memory area whose operation is delayed due to deterioration even during a period in which the onboard control system operates normally, and to predict failure.

### Brief Description of Drawings

[FIG. 1] FIG. 1 is a block diagram illustrating an outline of an onboard control system according to a first embodiment.
[FIG. 2] FIG. 2 is a graph illustrating a relationship between a frequency used for diagnosis and a defective bit rate (number) of a deteriorated storage device in the first embodiment.
[FIG. 3] FIG. 3 is a block diagram illustrating an outline of an onboard control system according to a second embodiment.
[FIG. 4] FIG. 4 is a graph illustrating a state in which bit defects occurring in a storage device increase with lapse of time in a second embodiment.
[FIG. 5] FIG. 5 is a flowchart illustrating processing for performing failure prediction of a storage device in a second embodiment.
[FIG. 6] FIG. 6 is a block diagram illustrating an outline of an onboard control system according to a third embodiment.
[FIG. 7] FIG. 7 is a graph illustrating a relationship between a frequency used for diagnosis and a defective bit rate (number) of a deteriorated storage device in the third embodiment.
[FIG. 8] FIG. 8 is a graph illustrating a relationship between a voltage used for diagnosis and a defective bit rate (number) of a deteriorated storage device in the third embodiment.
[FIG. 9] FIG. 9 is a block diagram illustrating an outline of an onboard control system according to a fourth embodiment.
[FIG. 10] FIG. 10 is a graph illustrating a state in which bit defects occurring in a storage device increase with lapse of time in the fourth embodiment.
[FIG. 11] FIG. 11 is a flowchart illustrating processing for performing failure prediction of a storage device in the fourth embodiment.
[FIG. 12] FIG. 12 is a block diagram illustrating an outline of an onboard control system according to a fifth embodiment.
[FIG. 13] FIG. 13 is a graph illustrating a state in which bit defects occurring in a storage device increase with lapse of time in the fifth embodiment.
[FIG. 14] FIG. 14 is a flowchart illustrating processing for performing failure prediction of a storage device in the fifth embodiment.
[FIG. 15] FIG. 15 is a block diagram illustrating an outline of an onboard control system according to a sixth embodiment.
[FIG. 16] FIG. 16 is a graph illustrating a state in which bit defects occurring in a storage device increase with lapse of time in the sixth embodiment.
[FIG. 17] FIG. 17 is a flowchart illustrating processing for performing failure prediction of a storage device in the sixth embodiment.

### Description of Embodiments

Hereinafter, embodiments will be described with reference to the drawings.

### [First Embodiment]

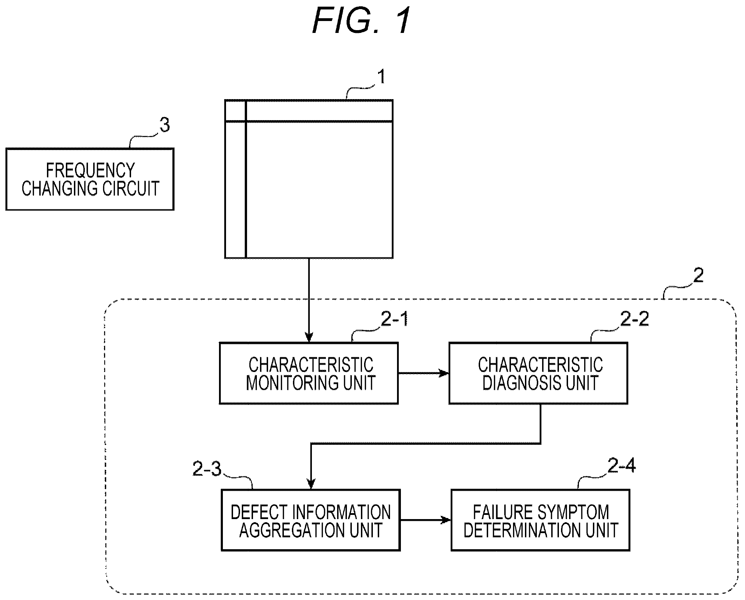

FIG. 1 is a block diagram illustrating a configuration of an onboard control system (hereinafter, it is simply referred to as a "system") according to a first embodiment of the present invention. The system according to the present embodiment is configured by a failure symptom diagnosis device 2 of a semiconductor storage device 1 and a frequency changing circuit 3 that changes an operation frequency of the semiconductor storage device with respect to the semiconductor storage device 1. The semiconductor storage device 1 includes, for example, an SRAM or a DRAM. The failure symptom diagnosis device 2 includes an arithmetic element including a Central Processing Unit (CPU) and a Read Only Memory (ROM). The frequency changing circuit 3 will be described later.

The failure symptom diagnosis device 2 according to the present embodiment performs, for example, an ALL=1/0 test, a Checker bord test, and the like on each memory cell of the semiconductor storage device 1, and reads the READ result from a value written in a memory cell by a characteristic monitoring unit 2-1. A characteristic diagnosis unit 2-2 checks whether the read result of the characteristic monitoring unit 2-1 matches the value written in each memory cell and determines PASS/FAIL of each memory cell. As a result of the determination, a defect information aggregation unit 2-3 aggregates the number of defective bits or the defective bit rate. A failure symptom determination unit 2-4 determines the deterioration state of the semiconductor storage device 1 as a diagnosis target from the value of the defective bit rate (number). Then, a time until the onboard control system causes malfunction due to the deterioration is calculated, and when the time during which the semiconductor storage device 1 is predicted to normally operate is shorter than a predetermined time, an alarm is issued to the driver.

The characteristic monitoring unit 2-1 may monitor an Error Collection Code (ECC) frequency or an ECC error rate instead of the READ result of the above-described test. The failure symptom diagnosis is preferably performed before the automobile travels.

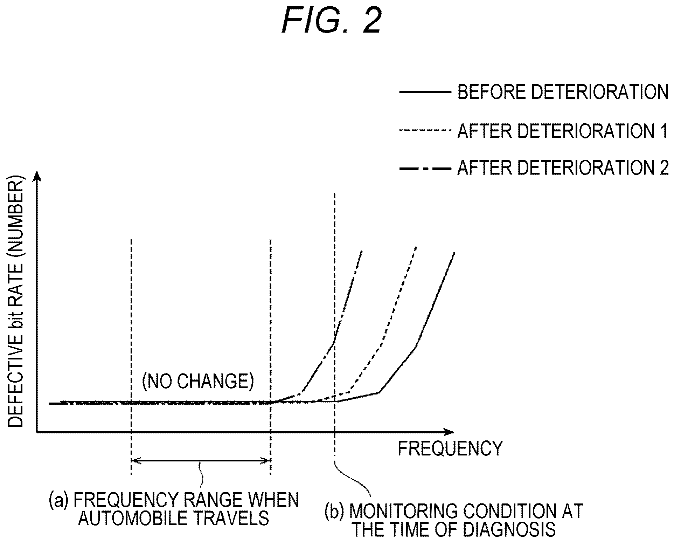

The frequency changing circuit 3 has a function of switching between an operation frequency during traveling of the automobile and an operation frequency during diagnosis, and performs diagnosis of the memory at a frequency higher than that during traveling of the automobile during the diagnosis. FIG. 2 illustrates frequency dependence of the defective bit rate (number) of the semiconductor storage device. A solid line indicates a state of the semiconductor storage device in a non-deteriorated state, a dotted line indicates a state of the semiconductor storage device in a slightly deteriorated state, and an alternate long and short dash line indicates a state of the semiconductor storage device in a further deteriorated state. As illustrated in FIG. 2, it can be seen that no defect occurs in the frequency range used when the automobile travels (during normal control) in any device, but in a case where the read time from the memory cell becomes long due to an increase in wiring resistance due to aged deterioration or the like, a defective bit in the deteriorated device is detected by performing diagnosis at a frequency (b) higher than the frequency range (a) when the automobile travels. That is, it is possible to detect that the operation speed becomes slow even at a stage where no abnormality occurs during automobile traveling (during normal control). In addition, since the detected defective bit rate is large in diagnosis using a high frequency, a change can be remarkably detected and a failure symptom can be detected.

### [Second Embodiment]

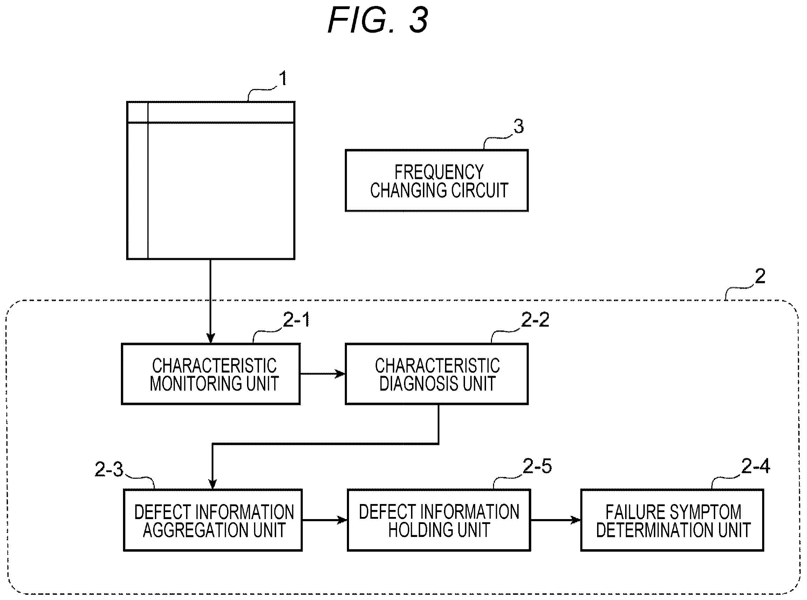

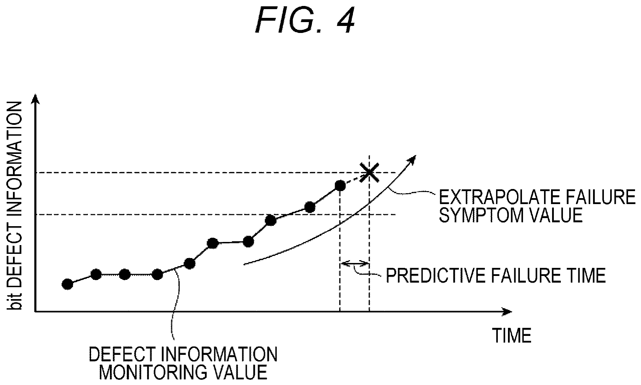

Next, an onboard control system according to a second embodiment of the present invention will be described. Hereinafter, the description of the functions and the like described so far will be omitted. FIG. 3 is a block diagram illustrating a configuration of the system according to the second embodiment. As illustrated in FIG. 3, the system according to the second embodiment further includes a defect information holding unit 2-5 in the failure symptom diagnosis unit 2 of the first embodiment. The defect information holding unit 2-5 holds the value aggregated by the defect information aggregation unit 2-3 and the elapsed time from the start of use of the semiconductor storage device in the nonvolatile memory inside thereof. The data held by the defect information holding unit 2-5 is the bit defect information illustrated in FIG. 4, that is, the data of the time-series transition of the defective bit rate (number) of the storage device. The failure symptom value illustrated in FIG. 4 is an increase rate of a defective bit rate calculated by a life prediction formula to be described later, and the predictive failure time indicates a time at which a failure is predicted to occur when the storage device continues to be used from the last diagnosis.

In the present embodiment, the failure symptom determination unit 2-4 applies a predetermined calculation formula to the most recently obtained value among the data held by the defect information holding unit 2-5 and extrapolates the failure symptom value. When the extrapolated value exceeds a predetermined value, it is determined that a failure occurs in the device, and an alarm is given to the driver.

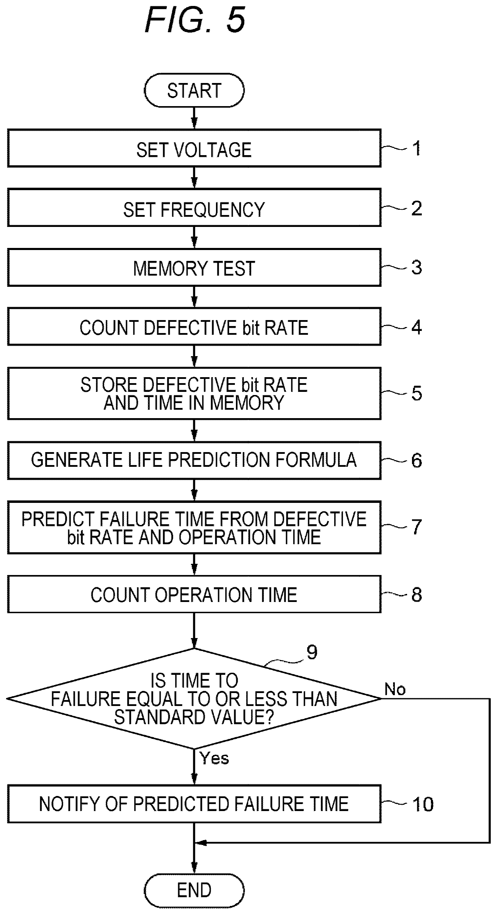

FIG. 5 illustrates a flow of failure symptom determination using time-series transition data of a defective bit rate. The characteristic monitoring unit 2-1 sets a voltage and a frequency in the storage device, performs a test, and reads a value written in the memory cell (Steps 1 and 2). Subsequently, the characteristic diagnosis unit 2-2 executes a memory test by determining whether the read result of the characteristic monitoring unit 2-1 matches the value actually written in the memory cell (Step 3). The defect information aggregation unit 2-3 aggregates the measured defect information (defective bit rate in the present embodiment) (Step 4).

The defect information holding unit 2-5 stores the defective bit rate and the elapsed time measured as a result of the memory test in the memory (Step 5). Then, the failure symptom determination unit 2-4 generates a life prediction formula predicted from the time-series transition of the defective bit rate, calculates the time to failure, and counts the elapsed time until the failure (Steps 6 to 8). Here, the life prediction formula is a calculation formula for predicting how much more the storage device to be used will fail, which is predicted from the measured defective bit rate and use time of the storage device to be used.

When the time to failure is equal to or less than a standard value ("Yes" in Step 9), an alarm is issued to notify the driver of the time to failure (Step 10). When the time to failure is larger than the standard value ("No" in Step 9), the memory is used as it is.

According to the present embodiment, it is possible to perform determination in consideration of the influence on degradation due to the difference in stress such as the frequency of use of the semiconductor device in the automobile and the temperature. Note that the defect information holding unit 2-5 holding the time-series transition data may transmit data to a computer server outside the vehicle by OTA and store the data instead of the onboard nonvolatile memory. In addition, the failure symptom determination may also be processed by a computer outside the vehicle, and the result may be notified to the vehicle by OTA.

### [Third Embodiment]

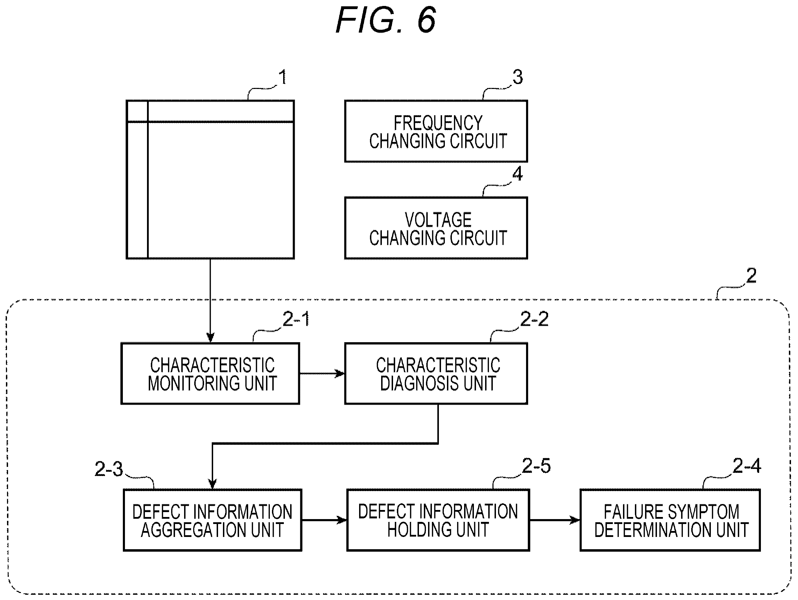

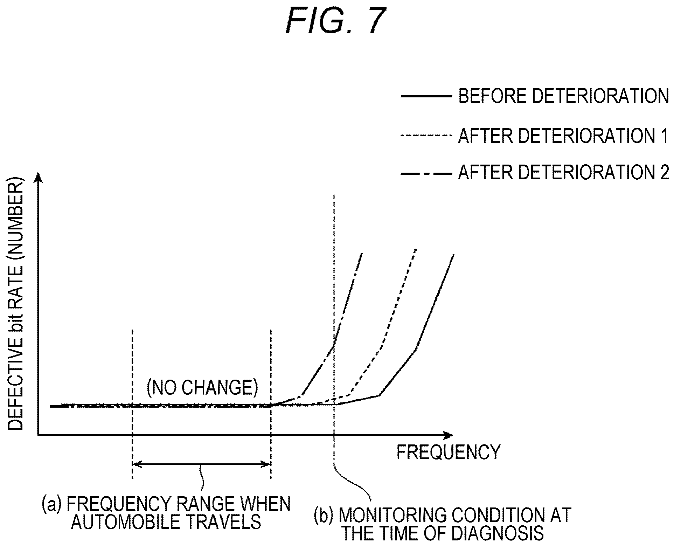

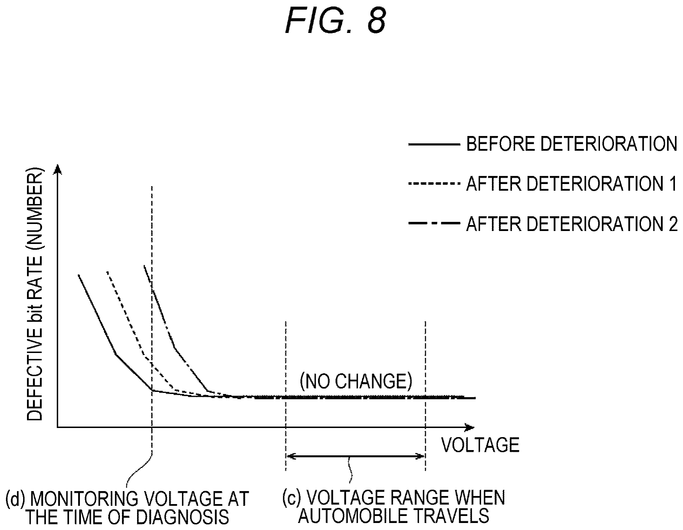

Next, an onboard control system according to a third embodiment of the present invention will be described. FIG. 6 is a block diagram illustrating a configuration of an onboard control system according to the third embodiment. As illustrated in FIG. 6, in the system according to the present embodiment, the system illustrated in FIG. 3 further includes a voltage changing circuit that changes a voltage for operating the semiconductor storage device. FIG. 7 is a graph illustrating the frequency dependence of the defective bit rate (number) of the storage device in which the deterioration similar to that in FIG. 2 occurs, but the same can be said for the voltage as illustrated in FIG. 8. That is, as the operating voltage at the time of diagnosis of the semiconductor storage device becomes lower than the voltage when the automobile travels, it is possible to detect a defective bit in the deteriorated storage device. As described above, by diagnosing the semiconductor storage device under the condition of a low voltage in addition to a high frequency, it is possible to predict the failure symptom not only by degradation of the operation speed but also by reduction of the charge amount of the memory cell and the change in the threshold voltage.

### [Fourth Embodiment]

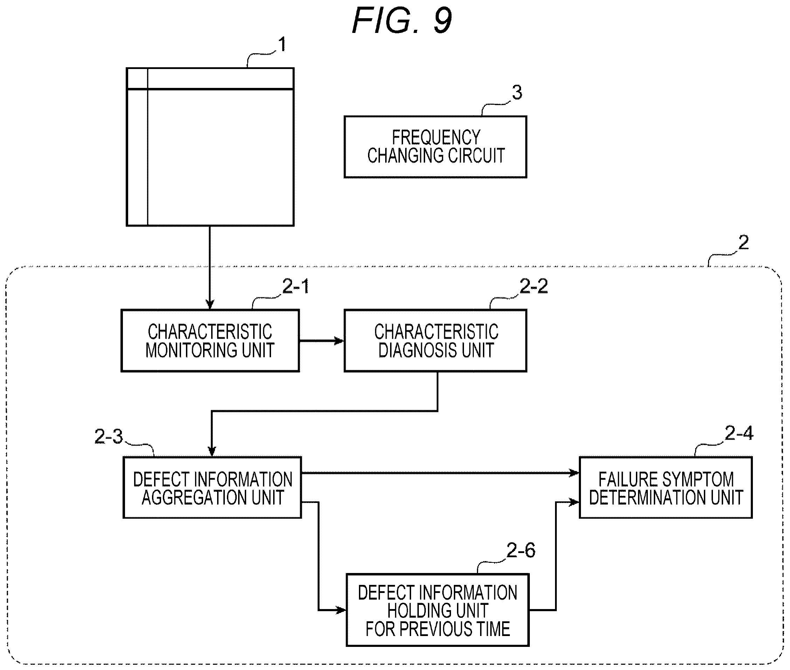

Next, an onboard control system according to a fourth embodiment will be described. As illustrated in FIG. 9, a system according to the fourth embodiment has a configuration in which the defect information holding unit is changed from the configuration of the second embodiment illustrated in FIG. 3 to a holding unit 2-6 that holds only the defect information rate at the time of diagnosis one time before, that is, the latest defect information rate.

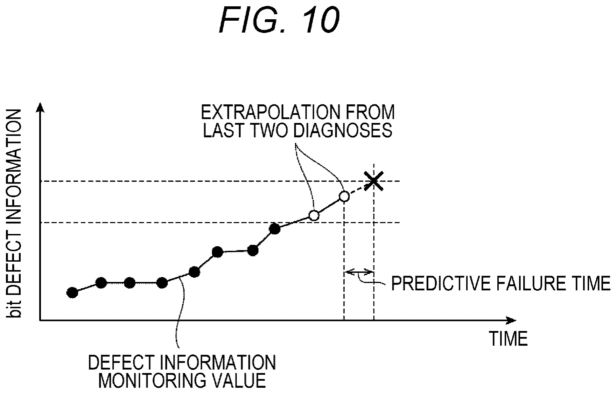

FIG. 10 is a graph for explaining a method of predicting a failure symptom in the present embodiment. As illustrated in FIG. 10, the rate of change in deterioration is calculated from the defect information in the last two diagnosis results, that is, the defect information from the latest diagnosis result and the diagnosis result one time before the latest diagnosis result, and the time therebetween, and the failure symptom is predicted.

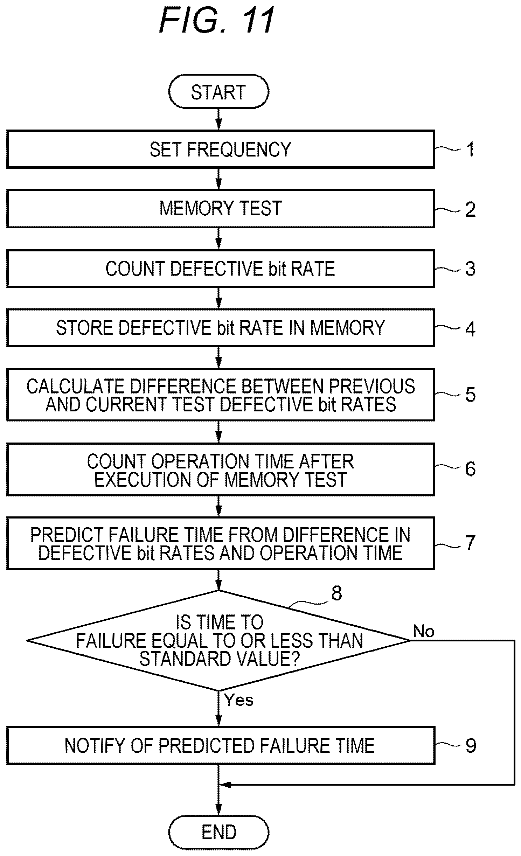

FIG. 11 is a flowchart for determining a failure symptom in this configuration. Steps 1 to 3 in FIG. 11 are the same as those in the above embodiment. In Step 4, the defect information holding unit for previous time 2-6 holds only the defective bit rate. This is because the elapsed time is used only when the defect information is accumulated and held. Then, in Step 5, the failure symptom determination unit 2-4 calculates an increment of the defective bit rate in the last diagnosis and the diagnosis one time before, counts the time between the last diagnosis and the previous diagnosis in Step 6, and calculates the time until the defective bit rate exceeds the failure determination criterion at which it is determined that the system will malfunction. When the time to failure is equal to or less than the standard value ("Yes" in Step 8), an alarm is issued to notify the driver of the time to failure (Step 9). In a case where the time to failure is larger than the standard value, the memory is used as it is ("No" in Step 8).

According to the present embodiment, the capacity of the nonvolatile memory for holding the time-series data of the memory cell defect rate can be reduced, and the circuit of the failure symptom determination unit can also be reduced.

### [Fifth Embodiment]

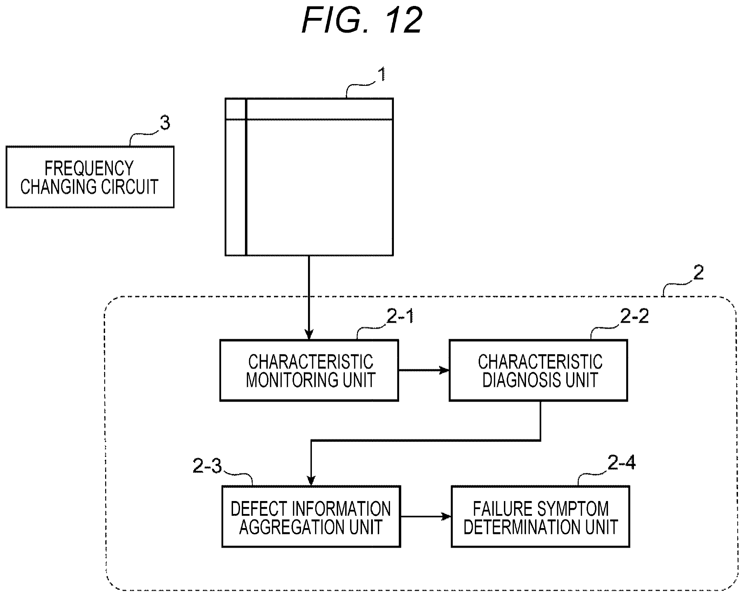

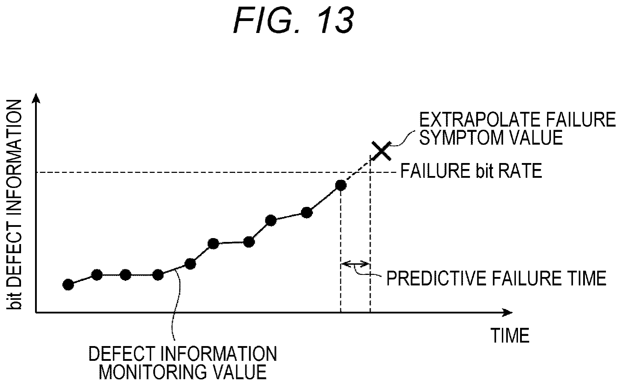

Next, an onboard control system according to a fifth embodiment will be described. The configuration of the system according to the present embodiment is similar to that of the first embodiment as illustrated in FIG. 12. In the present embodiment, the defect information holding unit as in the second to fourth embodiments is not provided, and a failure symptom is notified when a final diagnosis result exceeds a predetermined defect rate threshold (defective bit determination reference value) as illustrated in FIG. 13. That is, a predetermined life prediction formula is applied to the final diagnosis result, and when the calculation result exceeds a predetermined threshold, it is diagnosed that there is the symptom of failure. However, in the case of the present embodiment, since the time-series data of the bit defect information as in the above embodiment cannot be used, the life prediction formula determined in advance for each storage device is used.

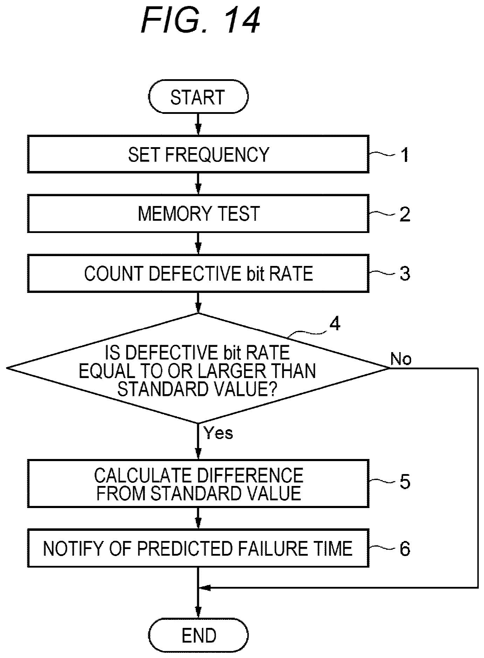

FIG. 14 illustrates the determination flow. Steps 1 to 3 are similar to the embodiments described above. The failure symptom determination unit 2-4 measures the number of failure bits in Step 4, and calculates a difference from the standard value in Step 5 when the number of failure bits is equal to or larger than the standard value. The increase in the defect rate with respect to time from that time point is set to a constant value, the time until failure is calculated, the failure is predicted, and the calculated predicted time until failure is notified (Step 6).

According to the present embodiment, since the system does not include the memory that holds the time-series data of the defect information, the failure symptom diagnosis unit can be made smaller.

### [Sixth Embodiment]

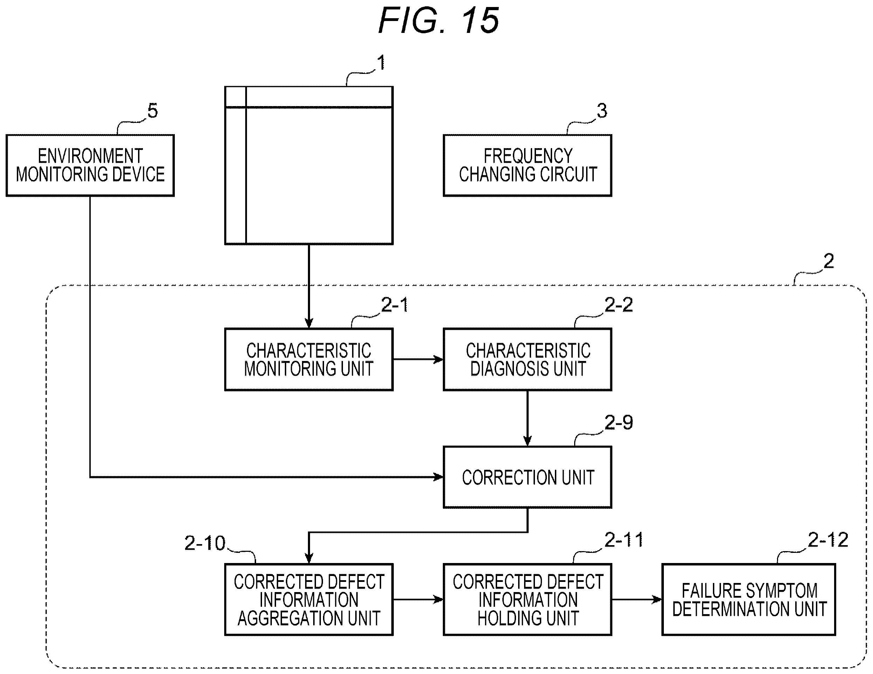

Next, an onboard control system according to a sixth embodiment will be described. FIG. 15 is a block diagram illustrating an outline of a system according to the present embodiment. As illustrated in FIG. 15, the system according to the present embodiment has a configuration further including an environment monitoring device 5 and a correction unit 2-9 that corrects a diagnosis result of the semiconductor storage device by an environmental monitoring value, in addition to the configuration of the second embodiment illustrated in FIG. 3. In addition, each of an aggregation unit 2-10 and a holding unit 2-11 corresponds to the corrected information.

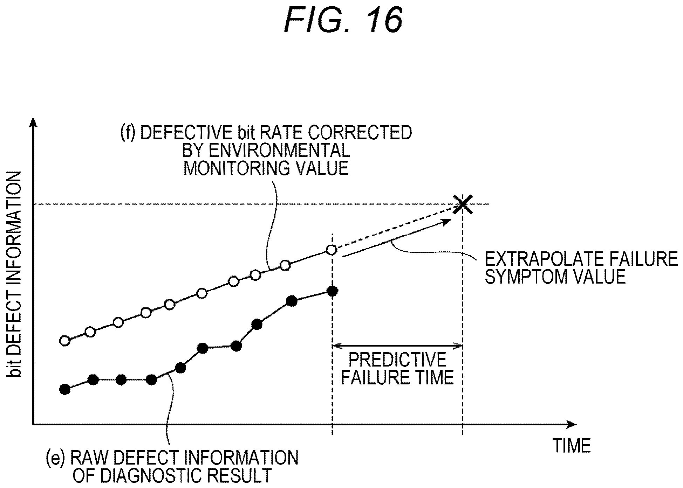

Aged deterioration of the semiconductor device is affected by a temperature, a current value, a voltage value, and the like at the time of use. As indicated by a black circle (e) in FIG. 16, the change rate of the time series transition of the raw defect rate changes due to the influence of the use environment, and thus, when the failure symptom is predicted using this data, an error increases. It is possible to improve the prediction accuracy of the change as illustrated by a white circle (f) in FIG. 16 by correcting the aged deterioration of the semiconductor storage device with the environmental monitoring value such as the temperature, the current value, and the voltage value at the time of use. Specifically, for example, in a case where the temperature at the time of diagnosis is lower than the average temperature, it is considered that more defects occur under a higher temperature environment than that at the time of normal use, and thus, correction is performed to further increase the bit defect rate (number) as illustrated in FIG. 16.

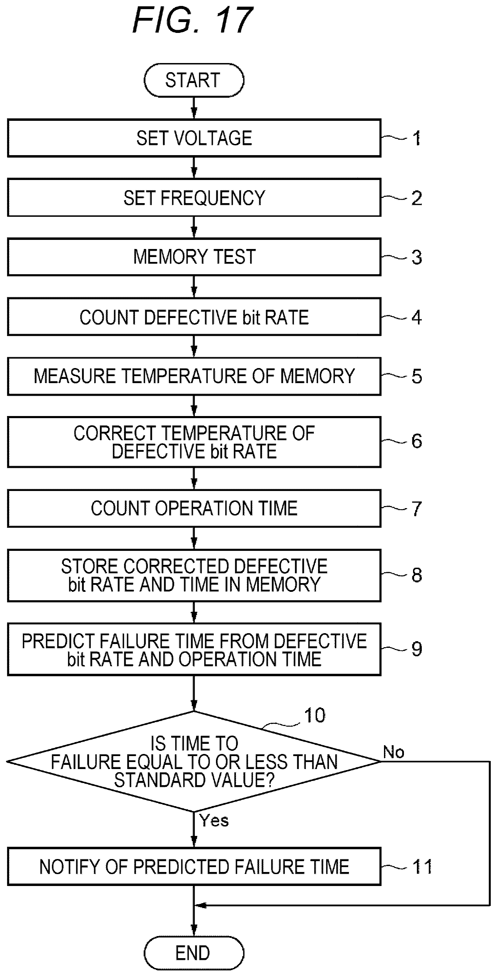

FIG. 17 illustrates a predictive diagnosis flow in a case where the environmental monitoring value is a temperature. Steps 1 to 4 are similar to the embodiments described above. The characteristic diagnosis unit 2-2 measures the temperature of the memory in Step 5. In Step 6, the correction unit 2-9 corrects the defective bit rate based on the temperature measurement result. In the next Step 7, the operation time is counted by the corrected defect information aggregation unit 2-10, and in the Step 8, the corrected defect information holding unit stores these pieces of information in the memory. In Step 9, the failure symptom determination unit 2-12 predicts the failure time from the corrected defective bit rate and the operation time. When the time to failure is equal to or less than the specified value ("Yes" in Step 10), an alarm is issued to notify the driver (Step 11). When the time to failure is larger than the specified value, the memory is used as it is ("No" in Step 10).

According to the present embodiment, it is possible to perform more accurate diagnosis by correcting measurement conditions.

In the present embodiment, the environment monitoring device 5 monitors the temperature at the time of use, but the present invention is not limited thereto, and the environment monitoring device 5 may monitor the ambient temperature of the semiconductor storage device or the voltage for operating the semiconductor storage device.

Note that, in the above embodiment, the frequency at the time of diagnosis of the semiconductor storage device is a frequency higher than the frequency of the electronic control device when the automobile travels, and in the frequency dependence of the defective bit rate at the time of shipping the semiconductor device, the frequency at which the defective bit rate starts to increase is used.

According to the embodiments of the present invention described above, the following operational effects are obtained.
(1) An onboard control system according to an embodiment of the present invention includes: a storage device that is used in controlling an automobile; a characteristic monitoring unit configured to monitor a characteristic of the storage device; a frequency changing unit that changes an operation frequency of the storage device to a second frequency, which is higher than a first frequency that is a frequency used in normal control of the automobile, when the characteristic monitoring unit monitors the characteristic of the storage device; and a determination unit that determines a failure symptom of the storage device based on a monitoring result of the characteristic monitoring unit.
   With the above configuration, even during a period in which the onboard control system is operating normally, it is possible to detect a memory area whose operation is delayed due to deterioration, and to predict failure.
(2) A failure symptom diagnosis device further includes a defect information aggregation unit that aggregates defect information including any of the number of defective bits, an ECC frequency, and the number of ECC errors output from the characteristic monitoring unit, and a defect information holding unit that holds the defect information, and the determination unit determines the failure symptom of the storage device based on time-series data held in the defect information holding unit. By using such specific time-series data, (1) can be efficiently realized.
(3) The onboard control system further includes a defect information aggregation unit that aggregates defect information including any of the number of defective bits, an ECC frequency, and the number of ECC errors output from the characteristic monitoring unit, and a defect information holding unit that holds the defect information, and the determination unit determines the failure symptom of the storage device based on time-series data held in the defect information holding unit. By using such specific time-series data, (1) can be efficiently realized.
(4) The onboard control system further includes a voltage changing unit that changes a power supply voltage of the storage device to a second voltage lower than a first voltage which is a voltage used during the normal control of the automobile when the characteristic monitoring unit monitors a characteristic of the storage device. In this way, by performing diagnosis using not only the frequency but also the voltage, more multifaceted diagnosis can be performed.
(5) The determination unit determines the failure symptom of the storage device based on a difference between defect information based on a previous monitoring result held in the defect information holding unit and the defect information based on a latest monitoring result, and an operation time from previous monitoring to latest monitoring. As a result, since it is sufficient to hold only the monitoring results of the latest two times, the capacity of the memory can be reduced.
(6) A predetermined symptom value is extrapolated to the latest defect information, and a failure symptom of the storage device is determined in a case where a result of the extrapolation exceeds a predetermined threshold. As a result, since it is not necessary to hold the data so far, it is not necessary to prepare a data holding memory.
(7) The onboard control system further includes an environment monitoring device that monitors operating environment data at the time of monitoring by the characteristic monitoring unit, the failure symptom diagnosis device further includes a correction unit that corrects an output result of the characteristic monitoring unit based on a monitoring result of the environment monitoring device, and the defect information holding unit holds the defect information corrected by the correction unit. This enables more accurate diagnosis based on the corrected monitoring result.
(8) The operating environment data is an ambient temperature or a voltage of the storage device. In the present invention, these data can be suitably utilized.
(9) A frequency condition used when the characteristic monitoring unit monitors the characteristic of the storage device is a frequency condition in which malfunction occurs at shipment of the storage device. By adopting such a condition, it is possible to determine a deteriorated storage device.

Note that the present invention is not limited to the above embodiments, and various modifications are possible. For example, the above-described embodiments have been described in detail in order to describe the present invention in an easy-to-understand manner, and the present invention is not necessarily limited to an aspect including all the described configurations. Further, a part of the configuration of one embodiment can be replaced with the configuration of another embodiment. In addition, the configuration of another embodiment can be added to the configuration of a certain embodiment. In addition, a part of the configuration of each embodiment can be deleted, or another configuration can be added or replaced.

### Reference Signs List

- 1: semiconductor storage device
- 2: failure symptom diagnosis device
- 2-1: characteristic monitoring unit
- 2-2: characteristic diagnosis unit
- 2-3: defect information aggregation unit
- 2-4: failure symptom determination unit
- 2-5: defect information holding unit
- 2-9: correction unit
- 3: frequency changing circuit
- 4: voltage changing circuit
- 5: environment monitoring device

## Claims

1. An onboard control system comprising:
a storage device that is used in controlling an automobile;
a failure symptom diagnosis device that diagnoses a failure symptom of the storage device; and
a frequency changing circuit that changes an operation frequency of the storage device to a second frequency, which is higher than a first frequency that is a frequency used during normal control of the automobile, when the failure symptom diagnosis device diagnoses the storage device.

2. The onboard control system according to claim 1, wherein the failure symptom diagnosis device includes
a characteristic monitoring unit configured to monitor a characteristic of the storage device, and
a determination unit that determines the failure symptom of the storage device based on a monitoring result of the characteristic monitoring unit.

3. The onboard control system according to claim 2, wherein the failure symptom diagnosis device includes
a defect information aggregation unit that aggregates defect information including any of the number of defective bits, an ECC frequency, and a number of ECC errors output from the characteristic monitoring unit, and
a defect information holding unit that holds the defect information, and
the determination unit determines the failure symptom of the storage device based on time-series data held in the defect information holding unit.

4. The onboard control system according to claim 2, further comprising a voltage changing circuit that changes a power supply voltage of the storage device to a second voltage lower than a first voltage which is a voltage used during the normal control of the automobile when the characteristic monitoring unit monitors a characteristic of the storage device.

5. The onboard control system according to claim 3, wherein the determination unit determines the failure symptom of the storage device based on a difference between defect information based on a previous monitoring result held in the defect information holding unit and the defect information based on a latest monitoring result, and an operation time from previous monitoring to latest monitoring.

6. The onboard control system according to claim 3, wherein the determination unit extrapolates a predetermined symptom value to the latest defect information, and determines a failure symptom of the storage device when a result of the extrapolation exceeds a predetermined threshold.

7. The onboard control system according to claim 3, further comprising an environment monitoring device that monitors operating environment data at the time of monitoring by the characteristic monitoring unit,
wherein the failure symptom diagnosis device further includes a correction unit that corrects an output result of the characteristic monitoring unit based on a monitoring result of the environment monitoring device, and
the defect information holding unit holds the defect information corrected by the correction unit.

8. The onboard control system according to claim 7, wherein the operating environment data is an ambient temperature or a voltage of the storage device.

9. The onboard control system according to claim 2, wherein a frequency condition used when the characteristic monitoring unit monitors the characteristic of the storage device is a frequency condition in which malfunction occurs at shipment of the storage device.
